# EUROPEAN PATENT APPLICATION

(11) **EP 4 685 524 A1**
(43) Date of publication of application: **28.01.2026**
(21) Application number: 24190741.9
(22) Date of filing: 24.07.2024
(51) Int. Cl.: G01S 19/36, G01S 19/37, H04B 1/26, H03D 3/00, H03D 7/14, H03D 7/16

(54) **A RECEIVER SYSTEM**

(71) Applicant: u-blox AG, 8800 Thalwil (CH)
(72) Inventor: BEAMISH, Norman, Cork (IE); MORLEY, Brian, Cork (IE); McCULLAGH, Mici, Lisbum (GB)
(74) Representative: Elkington and Fife LLP

(57) **Abstract**

There is provide a system comprising a plurality of receivers, each receiver comprising a local oscillator configured to generate a local oscillation signal, a primary mixer configured to mix an input signal with a reference signal at a reference frequency to generate a first output signal, a divider configured to divide the reference signal into a second reference signal at a second frequency and a secondary mixer coupled to the primary mixer and configured to mix the first output signal and the second reference signal at the second frequency. In a first mode, the reference signal for a first of a plurality of the receivers is the local oscillation signal from the first receiver and, in a second mode, the reference signal is the local oscillation signal from another of the plurality of receivers.

## Description

### FIELD OF THE INVENTION

The present invention relates to a receiver for receiving and tracking multiple satellite bands simultaneously at a reduced power . In particular, it relates to a system including a discrete-time superheterodyne mixer and methods of operating the system.

### BACKGROUND OF THE INVENTION

Techniques for GNSS (Global Navigation Satellite Systems) positioning are well known in the art. Existing GNSS include the Global Positioning System (GPS), Galileo, GLONASS, QZSS and NAVIC and BeiDou Navigation Satellite System (BDS), also referred to herein as simply "BeiDou". Each GNSS comprises a constellation of satellites, also known in the art as "space vehicles" (SVs), which orbit the earth. Typically, each SV transmits a number of satellite signals. These are received by a GNSS receiver whose position it is desired to calculate. The GNSS receiver can make a number of ranging measurements using the signals, to derive information about the distance between the receiver and respective satellites. When a sufficient number of measurements can be made, the receiver's position can then be calculated by multilateration.

Moreover, when multiple satellite signals belonging to different frequency bands need to be tracked at the same time, a complete radio receiver is typically required for each frequency band. Each receiver independently downmixes a particular satellite signal requiring a separate frequency synthesiser to generate the mixing signals for each receiver. This comes at a power penalty since each receiver consumes approximately the same amount of power.

It is thus an object of the present invention to introduce and operate a radio receiver being capable to receive signals from different frequency bands concurrently at a reduced power.

### SUMMARY OF THE INVENTION

According to the invention there is provided a system comprising a plurality of receivers, each receiver comprising:
a local oscillator configured to generate a local oscillation signal;
a primary mixer configured to mix an input signal with a reference signal at a reference frequency to generate a first output signal;
a divider configured to divide the reference signal into a second reference signal at a second frequency;
a secondary mixer coupled to the primary mixer and configured to mix the first output signal and the second reference signal at the second frequency,
wherein, in a first mode, the reference signal for a first of a plurality of the receivers is the local oscillation signal from the first receiver and, in a second mode, the reference signal is the local oscillation signal from another of the plurality of receivers.

In the second mode, the local oscillator of the first receiver may be switched off and the system can operate in a low power mode. A single local oscillator may provide reference signals to all of the receivers and all the other local oscillators may be switched off.

The system may be configured to switch between the first mode and the second mode based on the signal characteristics of the input signal to at least one of the receivers. Thus, the second power mode may be used only when the signal characteristics are suitable. The signal characteristics may comprise at least one of the signal to noise ratio, the bit error rate, the Fourier transform of the input signal. For example, the second mode may be used only when the signal to noise ratio is above a predetermined threshold.

The system may be configured to switch between the first mode and the second mode based on the signal characteristic of any one signal passing a predetermined threshold.

The frequency of the second reference signal is f_{R}/N, where f_{R} is a frequency of the reference signal, and N is an integer.

The primary mixer of each receiver may be configured to shift the signal to an intermediate frequency determined by a difference between a frequency of the input signal and a frequency of the reference signal such that the receiver operates in a super-heterodyne mode.

The primary mixer of each receiver may be configured to sample the input signal at a plurality of discrete points in time to obtain a discrete-time sampled analog signal based on the reference signal.

The primary mixer may comprise:
a first primary sub-mixer comprising a plurality of in-phase switches including first, second, third, and fourth in-phase switches; and
a second primary sub-mixer comprising a plurality of quadrature-phase switches including first, second, third, and fourth quadrature-phase switches,
and wherein:
the secondary mixer comprises a first set of switches, a second set of switches, a third set of switches, and a fourth set of switches, wherein each of the first, second, third, and fourth sets of switches includes, respectively, a first, a second, a third, and a fourth switch connected in parallel,
an output of each of the first, second, third, and fourth in-phase switches of the primary mixer is coupled to the first set, second set, third set, and fourth set of switches, respectively, of the secondary mixer, and
an output of each of the first, second, third, and fourth quadrature-phase switches of the primary mixer is coupled to the first set, second set, third set, and fourth set of switches, respectively, of the secondary mixer,

Each receiver may further comprise a filter coupled to the secondary mixer and configured to filter an output signal from the second mixer, wherein:
the filter comprises a first capacitor and a second capacitor,
outputs of the first set of switches of the secondary mixer are coupled to a first terminal of the first capacitor of the filter and outputs of the second set of switches of the secondary mixer are coupled to a second terminal of the first capacitor of the filter, and
outputs of the third set of switches of the secondary mixer are coupled to a first terminal of a second capacitor of the filter and outputs of the fourth set of switches of the secondary mixer are coupled to a second terminal of the second capacitor of the filter.

The first mixer may comprise an eight phase mixer and the second mixer comprises an eight phase mixer.

The second reference signal may be offset in phase from the input signal by 2πn/N where n ε [0,... ,N-1].

The secondary mixer may comprise a first secondary mixer and a second secondary mixer connected in parallel and each of the first and second secondary mixers comprises a first set of switches, a second set of switches, a third set of switches, and a fourth set of switches, wherein each of the first, second, third, and fourth sets of switches includes, respectively, a first, a second, a third, and a fourth switch connected in parallel. An output of each of the first, second, third, and fourth in-phase switches of the first primary mixer may be coupled to the first set, second set, third set, and fourth set of switches, respectively, of the first and second secondary mixers. An output of each of the first, second, third, and fourth quadrature-phase switches of the second primary mixer is coupled to the first set, second set, third set, and fourth set of switches, respectively, of the first and second secondary mixers, and the second switch and the fourth switch in each of the first, second, third and fourth sets of switches in the first secondary mixer respectively correspond to the fourth switch and the second switch in each of the first, second, third and fourth sets of switches in the second secondary circuit.

According to the invention there is a method for processing a plurality of input signals, each of the plurality of input signals being received by a plurality of respective receivers, the method comprising, at each receiver:
generating a local oscillation signal;
mixing the input signal with a reference signal to generate a first output signal; and
dividing the reference signal into a second reference signal at a second frequency;
mixing the first output signal with the second reference signal at the second frequency;
the method comprising switching between a first mode in which the reference signal for a first receiver is the local oscillation signal from the first receiver and a second mode in which the reference signal is the local oscillation signal from another of the plurality of receivers.

Switching between the first mode and the second mode may be based on the signal characteristics of the input signal to at least one of the receivers.

### BRIEF DESCRIPTION OF THE DRAWINGS

The invention will now be described by way of example with reference to the accompanying drawings, in which:
Fig. 1 is a schematic block diagram illustrating a receiver;
Fig. 2 is a schematic block diagram of a receiver;
Figure 3 is a schematic block diagram of a plurality of receivers;
Figure 4 is a schematic block diagram of a plurality of receivers
Figure 5 depicts a schematic block diagram of a receiver; and
Figure 6 depicts an eight phase waveform.

It should be noted that these figures are diagrammatic and not drawn to scale.

### DETAILED DESCRIPTION

Reference will now be made in detail to embodiments of the invention, examples of which are illustrated in the accompanying drawings. The described embodiments should not be construed as being limited to the descriptions given in this section; the embodiments may have different forms.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the present disclosure. Instead, they are merely examples of systems, apparatuses, and methods consistent with aspects related to the present disclosure as recited in the appended claims.

A zero-IF receiver typically uses a passive sampling mixer and is vulnerable to interference caused by blockers located at odd harmonic frequencies of the fundamental carrier. The interference caused by blockers may be suppressed by adding a lowpass filter at the receiver input. However, such a lowpass filter may cause increased size of the receiver and increased cost to the receiver design. Moreover, such a lowpass filter may cause an insertion loss in the receiver signal path, thereby degrading performance of the receiver.
The problem of the harmonic blockers may be mitigated by adopting a superheterodyne receiver. However, a superheterodyne receiver typically has off-chip architecture, and requires costly, power-hungry filters for image rejection. It is therefore desirable to have an on-chip integrated receiver that does not require lowpass filters and does not have a vulnerability to the harmonic blockers.
Moreover, for Long-Term Evolution (LTE) Carrier Aggregation (CA) receivers and/or GNSS receivers receiving signals from different frequency bands a receiver is required to receive signals at two or more frequencies simultaneously. This typically requires the generation of two or more distinct carrier frequencies. This frequency generation process may result in the generation of unwanted frequency spurs which can then in turn combine with the transmitted signal to create interference. The likelihood of unwanted spurs increases as the number of CA components increases. In 5G LTE for example, there are up to 16 CA components.

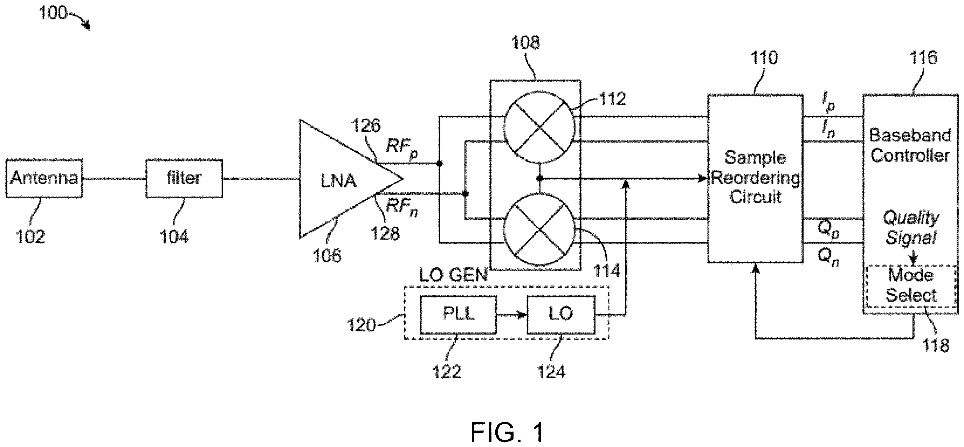

FIG. 1 is a schematic diagram illustrating a receiver. Receiver 100 includes an antenna 102, a filter 104, a low-noise amplifier (LNA) 106, a mixer 108, a sample reordering circuit 110, a baseband controller 116 including a mode selector 118, and a local oscillating signal (LO) generator 120. Mixer 108 includes a first mixer 112 and a second mixer 114. LO generator 120 includes a phase-locked loop (PLL) circuit 122 and a local oscillating signal (LO) constructor 124. Antenna 102 may be configured to receive signals from one or more sources. In some embodiments, a signal received by antenna 102 may be a radio frequency (RF) signal in communication systems. However, the signals are not so limited, such that the signals received by antenna 102 can be any electromagnetic waves transmitted from any sources.

A signal received by antenna 102 is first passed through filter 104 (e.g., a bandpass filter) to suppress frequencies outside a range of interest. The filtered signal is then passed to LNA 106 and amplified by LNA 106. In an embodiment, LNA 106 may include a controller that controls parameters of an amplified signal. The parameters may include at least one of: gain, noise, linearity, bandwidth, output dynamic range, slew rate, rise rate, overshoot, or stability factor. In an embodiment, filter 104 is not implemented in receiver 100 and LNA 106 is directly coupled to antenna 102.

LNA 106 may be a single-input to differential-outputs amplifier, for example, as shown in FIG. 1. LNA 106 may instead be a differential-inputs to differential-outputs amplifier. In FIG. 1, LNA 106 includes a positive differential output 126 that outputs a signal having a positive component (e.g., an RF voltage signal having a positive component expressed as RFp), and a negative differential output 128 that outputs a signal having a negative component (e.g., an RF voltage signal having a negative component expressed as RFn). In an embodiment, LNA 106 may be optional and can be omitted.

Mixer 112 may be an in-phase mixer and mixer 114 may be a quadrature phase mixer. In this embodiment, in-phase mixer 112 may be coupled to differential outputs 126 and 128 of LNA 106 and configured to receive a positive signal from positive differential output 126 and a negative signal from negative differential output 128. Similarly, quadrature phase mixer 114 may be coupled to the differential outputs 126 and 128 of LNA 106 and configured to receive a positive signal from positive differential output 126 and a negative signal from negative differential output 128. Each of mixers 112 and 114 may be configured to sample the received amplified signal at a plurality of discrete points in time to obtain a discrete-time sampled signal based on a local oscillating signal provided by LO generator 120.

The discrete-time sampled signals obtained by mixers 112 and 114 are then transmitted to sample reordering circuit 110 that is coupled to mixers 112 and 114. Sample reordering circuit 110 is configured to change a sequence of the samples received from mixers 112 and 114, by performing another sampling on the samples received from mixers 112 and 114. In an embodiment, the sampling in sample reordering circuit 110 is controlled by a clock signal generated by LO generator 120. The clock signal may be generated by dividing the local oscillating signal generated for mixer 108.

LO generator 120 may include a reference oscillator such as a crystal oscillator or a voltage-controlled oscillator, or the like (not shown) that generates a reference signal. PLL 122 receives the reference signal and generates an oscillator signal. LO constructor 124 receives the oscillator signal from PLL 122 and generates a local oscillating signal for receiver 100. The local oscillating signal generated by LO constructor 124 is the local oscillating signal provided to mixer 108. A frequency of the local oscillating signal for mixer 108 may be expressed as fLO. In an embodiment, LO constructor 124 includes a frequency divider that divides the frequency fLO to generate an additional local oscillating signal that is used as a clock signal for sample reordering circuit 110. A frequency of the clock signal for sample reordering circuit 110 may be expressed as fLO/N, where N is an integer. For example, if N=4, the frequency of the clock signal for sample reordering circuit 110 is fLO/4 and this clock signal controls the sampling in sample reordering circuit 110 and thereby controls a waveform of a sample-reordered signal. In an alternative embodiment, sample reordering circuit 110 may have its own clock signal generator independent from LO generator 120. In another embodiment, LO generator 120 may be configured to generate a plurality of different clock signals for sample reordering circuit 110.

Sample reordering circuit 110 performs a second sampling on the positive in-phase signal (Ip), the negative in-phase signal (In), the positive quadrature phase signal (Qp), and the negative quadrature phase signal (Qn) that were first sampled by mixers 112 and 114, and outputs the sampled signals to baseband controller 116. Baseband controller 116 checks quality of the sampled signals and determines a desired waveform. Based on the desired waveform, mode selector 118 of baseband controller 116 selects a mode and provides a feedback signal to sample reordering circuit 110. For example, if a current operating mode is a zero-IF mode and baseband controller 116 determines that quality of the sampled signals is not satisfactory, mode selector 118 may select a mode other than the zero-IF mode and provide a feedback signal to sample reordering circuit 110. Sample reordering circuit 110 determines a desired reordering sequence of the samples based on the feedback signal. In an alternative embodiment, sample reordering circuit 110 may provide a feedback signal (not shown) to LO generator 120 such that LO generator 120 can provide a desired clock signal to sample reordering circuit 110.

The mode selected by mode selector 118 may be a superheterodyne mode such that receiver 100 operates in a superheterodyne mode. In this embodiment, by a reordering operation, sample reordering circuit 110 shifts the sampled signal to an intermediate frequency determined by a difference between a frequency of the input signal and the frequency of the local oscillating signal. The amount of the shifting is determined by the feedback signal provided by mode selector 118.

By utilizing a sample reordering circuit, e.g., sample reordering circuit 110, coupled to a mixer, e.g., mixer 108, discrete-time samples outputted from the mixer are reordered, and thereby an effect of the superheterodyne receiver is achieved without implementing off-chip architecture and power-hungry filters. As a result, a local oscillating frequency can be a frequency different from a center frequency of a desired channel, thereby suppressing interference caused by harmonic blockers in zero-IF mode. Moreover, by using a discrete-time quadrature phase mixer, e.g., quadrature phase mixer 114, negative frequency image rejection is achieved, further enhancing signal quality.

Receivers that implement the sample reordering circuit may suppress interference caused by harmonic blockers, thereby enhancing signal quality, without utilizing costly filters for the blockers.

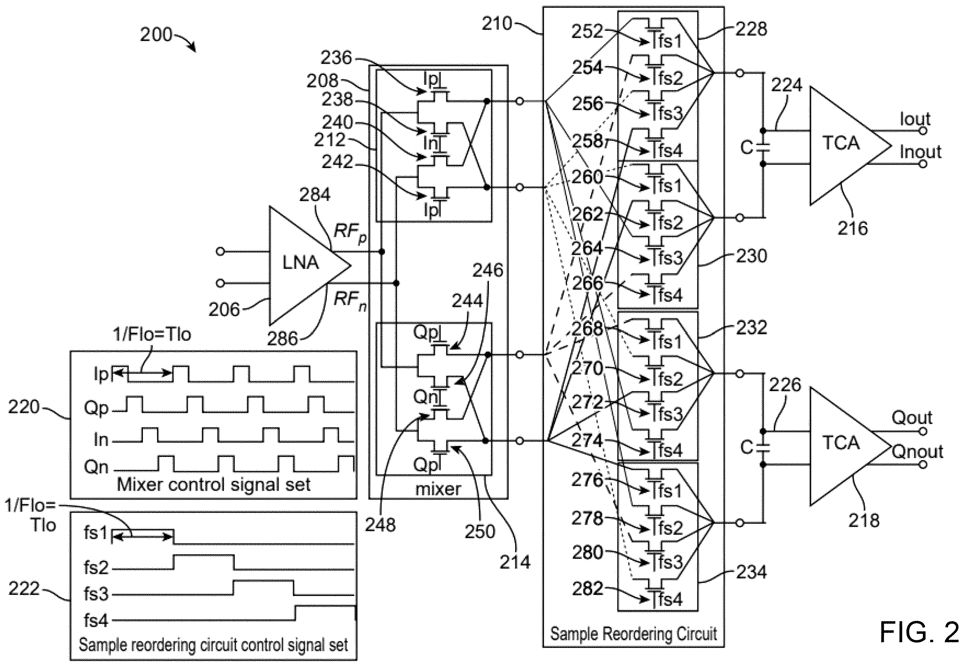

Figure 2 is a schematic diagram illustrating a configuration of a receiver. The receiver 200 includes a low-noise amplifier (LNA) 206, a mixer 208, and a sample reordering circuit 210. For clarity, figure 2 omits other components of receiver 200 such as an antenna, analog-to-digital converter, etc. A signal transmitted to LNA 206 may include differential signals and LNA 206 may be a differential-inputs to differential-outputs amplifier. LNA 206 includes a positive differential output 284 that outputs a signal having a positive component (e.g., an RF voltage signal having a positive component RFp), and a negative differential output 286 that outputs a signal having a negative component (e.g., an RF voltage signal having a negative component RFn). Each of the differential outputs 284 and 286 may output a signal to mixer 208.

Mixer 208 includes an in-phase mixer 212 and a quadrature phase mixer 214. In-phase mixer 212 includes transistors 236, 238, 240, and 242 arranged as shown in the figure, and quadrature phase mixer 214 includes transistors 244, 246, 248, and 250 arranged as shown in the figure. Each of the transistors in mixers 212 and 214 is controlled by a corresponding control signal, included in a mixer control signal set 220. Mixer control signal set 220 includes in-phase positive control signal Ip, quadrature phase positive control signal Qp, in-phase negative control signal In, and quadrature phase negative control signal Qn that are configured to control sampling of in-phase positive signals, quadrature phase positive signals, in-phase negative signals, and quadrature phase negative signals, respectively. Each of control signals Ip, Qp, In, and Qn is a pulsed signal. The four control signals Ip, Qp, In, and Qn have the same pulse width. The pulses of the four control signals Ip, Qp, In, and Qn are time shifted with respect to each other by the pulse width of the pulses. For example, when Ip falls from a high signal level to a low signal level so that the pulse is ending, Qp rises from a low signal level to a high signal level.

Within the in-phase mixer 212, transistor 236 is controlled by the in-phase positive control signal Ip (in signal set 220), transistors 238 and 240 are controlled by in-phase negative control signal In (in signal set 220), and transistor 242 is controlled by in-phase positive control signal Ip (in signal set 220). Similarly, in quadrature phase mixer 214, transistor 244 is controlled by the quadrature phase positive control signal Qp (in signal set 220), transistors 246 and 248 are controlled by quadrature phase negative control signal Qn (in signal set 220), and transistor 250 is controlled by quadrature phase positive control signal Qp (in signal set 220). Mixer control signal set 220 may be a local oscillating signal generated by a local oscillating signal generator, such as LO generator 120 in FIG. 1. A quadrature phase control signal may be generated from an in-phase control signal by a 90° phase shifting.

Each of the transistors in in-phase mixer 212 is coupled to differential outputs 284 and 286 of LNA 206 and configured to receive a positive signal from positive differential output 284 and a negative signal from negative differential output 286. Similarly, each of the transistors in quadrature phase mixer 214 is coupled to differential outputs 284 and 286 of LNA 206 and configured to receive a positive quadrature phase signal from positive differential output 284 and a negative quadrature phase signal from negative differential output 286. Each of the transistors in mixers 212 and 214 are configured to sample the received amplified signal at a plurality of discrete points in time to obtain a discrete-time sampled signal under the control of the control signals.

The discrete-time sampled signals obtained by mixers 212 and 214 are transmitted to sample reordering circuit 210 that is coupled to mixer 208. Sample reordering circuit 210 includes a first set of transistors 228 including transistors 252, 254, 256, and 258 connected in parallel, a second set of transistors 230 including transistors 260, 262, 264, and 266 connected in parallel, a third set of transistors 232 including transistors 268, 270, 272, and 274 connected in parallel, and a fourth set of transistors 234 including transistors 276, 278, 280, and 282 connected in parallel. Each set of transistors 228, 230, 232, and 234 has one transistor configured to receive a sampled positive in-phase signal from mixer 212, one transistor configured to receive a sampled negative in-phase signal from mixer 212, one transistor configured to receive a sampled positive quadrature phase signal from mixer 214, and one transistor configured to receive a sampled negative quadrature phase signal from mixer 214.

ON/OFF states of the transistors of sample reordering circuit 210 are controlled by a sample reordering circuit control signal set 222. Sample reordering circuit control signal set 222 includes control signals fs1, fs2, fs3, and fs4. Each of control signal fs1, fs2, fs3, and fs4 is a pulsed signal with pulse width Tlo. The pulses of the four control signals are time shifted with respect to each other by Tlo. For example, when fs1 falls from a high signal level to a low signal level when the pulse ends, fs2 rises from the low signal level to the high signal level. In an embodiment, sample reordering control signal set 222 is generated by dividing the frequency of the local oscillating signal generated for mixer 208 by 4. In this case, the pulse width of each of the pulses of sample reordering circuit control signal set 222 is four times the pulse width of the pulses of mixer control signal set 220. For example, during one pulse width of the signal fs1, the rising and ending of all four pulses Ip, Qp, In, and Qn occur.

Each set of transistors 228, 230, 232, and 234 of sample reordering circuit 210 has one transistor configured to receive fs1, one transistor configured to receive fs2, one transistor configured to receive fs3, and one transistor configured to receive fs4. By controlling the ON/OFF state and the duration of the ON/OFF state of the transistors, sample reordering circuit 210 selectively transmits one of the four signals (positive in-phase, negative in-phase, positive quadrature phase, and negative quadrature phase) outputted from mixer 208, thereby reordering a sequence of the time-discrete samples outputted from mixer 208.

In some embodiments, a filter may be coupled to the outputs of sample reordering circuit 210. For example, the filter may include capacitors 224 and 226. The outputs of first set of transistors 228 are coupled to a first terminal of capacitor 224, and the outputs of second set of transistors 230 are coupled to a second terminal of capacitor 224. Similarly, the outputs of third set of transistors 232 are coupled to a first terminal of capacitor 226, the outputs of fourth set of transistors 234 are coupled to a second terminal of capacitor 226. Capacitor 224 is coupled to a transconductance amplifier (TCA) 216 to output the filtered in-phase differential signals to TCA 216. Similarly, capacitor 226 is coupled to TCA 218 to output the filtered quadrature phase differential signals to TCA 218.

As explained above, in the exemplary embodiment shown in Figure 2, sample reordering circuit 210 includes sets of transistors. However, the sample reordering circuit is not so limited, and any switches or devices capable of selecting the samples outputted by mixer 208 may be implemented in the sample reordering circuit. Similarly, the transistors of the mixer 208 can be any type of transistors, switches, or devices capable of performing time-discrete sampling function.

The receiver depicted in figure 2 operates as described in US11,108,420, the entire contents of which are incorporated herein.

There may be a plurality of receivers, each to receive and demodulate a different frequency band. This allows different frequency bands to be received and demodulated simultaneously.

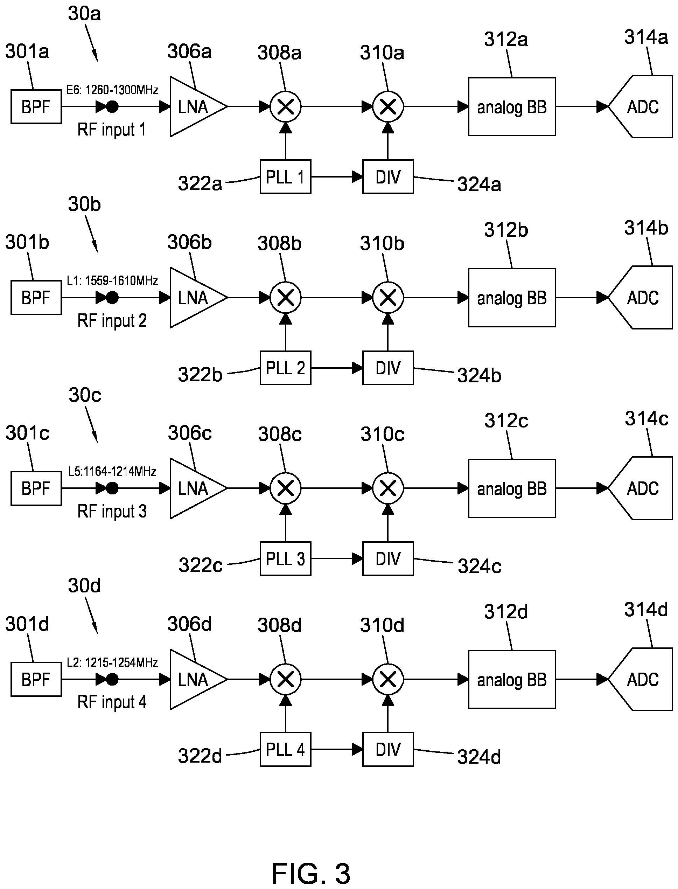

Figure 3 depicts a plurality of receivers 30a, 30b, 30c, 30d each with a band pass filter 301 (301a, 301b, 301c, 301d), a low noise amplifier 306 (306a, 306b, 306c, 306d), a primary mixer 308 (308a, 308b, 308c, 308d) a secondary mixer 310 (310a, 310b, 310c, 310d), an analog baseband (BB) 312 (312a, 312b, 312c, 312d) and an ADC 314 (314a, 314b, 314c, 314d). Each receiver has a local oscillator 322 (322a, 322b, 322c, 322d) which provides a local oscillation signal to the primary mixer. The local oscillator 322 (322a, 322b, 322c, 322d) also provides the local oscillation signal to a divider 324 (324a, 324b, 324c, 324d. The output of the divider is an input to the secondary mixer 310 (310a, 310b, 310c, 310d). Each receiver may operate as the receiver described in figure 2. In particular the primary mixers of each receiver of figure 3 operates in the same way as the primary mixer 208 of figure 2. Similarly, the secondary mixer of each receiver of figure 3 operates in the same way as the secondary mixer 210 depicted in figure 2.

Each receiver in figure 3 may be configured to demodulate a signal of a different frequency. For example, receiver 30a may be configured to demodulate a signal of 1279MHz, receiver 30b may be configured to demodulate a signal of 1574MHz, receiver 30c may be configured to demodulate a signal of 1181MHz and receiver 30d may be configured to demodulate a signal of 1240MHz. Local oscillator 322a of receiver 30a may generate a local oscillation signal of 1378MHz and the divider 324a divide the signal by 14 to generate an input to the secondary mixer of 98MHz. Consequently, a signal of frequency 1279MHz is demodulated.

Each of the local oscillators 322 generate oscillation signals having the same frequency. However, they need not all generate the same frequencies.

With a local oscillation signal of 1378Hz in each of the local oscillators, the divider of receiver 30b divides the oscillation signal by 7 to generate an input to the secondary mixer of 197MHz to demodulate the signal of 1574MHz. The divider of receiver 30c also divides the oscillation signal by 7 to generate an input to the secondary mixer of 197MHz to demodulate a signal of 1181MHz. The divider of receiver 30d divides the oscillation signal by 10 to generate an input to the secondary mixer of 138M Hz to demodulate a signal of 1240MHz. Each of the dividers divides the respective oscillation signal by an integer.

The system depicted in figure 3 requires a complete receiver for each frequency band to be demodulated. Each receiver independently demodulates a frequency signal, or band and an independent frequency generator is used to generate the mixer inputs for each receiver. Each receiver consumes roughly the same power and thus the power consumption can be a significant factor.

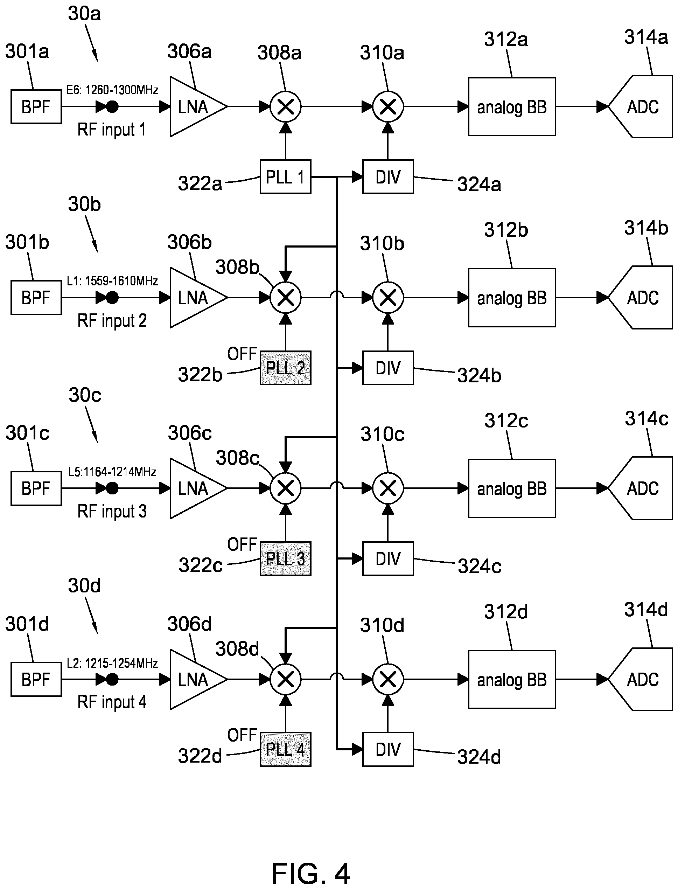

Figure 4 depicts an alternative arrangement in which a system comprising a plurality of receivers may be used in two modes. In a first mode, each of the receivers, 30a, 30b, 30c, 30d operates using its own frequency generator, similarly as in Fig. 3. In a second mode a single frequency generator (local oscillator) from one of the receivers is used to generate the input for each of the receivers. In this example, the local oscillator 322a from a first receiver 30a is used as input to the primary mixer 308 of each of the other receivers. The local oscillator 322a of the first receiver 30a is also used as an input to the dividers 324a, 324b, 324c, 324d of each of the four receivers 30a, 30b, 30c, 30d.

Examples of signal bands, including a maximum frequency and minimum frequency together with the centre frequency, the frequency input to the secondary mixer (IF mix) and the value by which the input signal is divided are given in the following table:

| fₘᵢₙ (MHz) | fₘₐₓ (MHz) | Band | LO (MHz) | IFmix (MHz) | f_{cent} (MHz) | BW (MHz) | VCO_div |
|---|---|---|---|---|---|---|---|
| 1260 | 1300 | E6 | 1378 | 98.42857 | 1279.57 | 20.43 | 14 |
| 1559 | 1610 | L1 | | 196.857 | 1574.86 | 35.14 | 7 |
| 1164 | 1214 | L5 | | 196.857 | 1181.14 | 32.86 | 7 |
| 1215 | 1254 | L2 | | 137.8 | 1240.20 | 25.20 | 10 |

Operated in the second mode, the local oscillators of receivers 30b, 30c and 30d need not be operated and can be switched off. Consequently, there is a lower power consumption compared to the arrangement depicted in figure 3. The disadvantage is that the receivers may be more susceptible to blockers.

The system may be switched between the arrangement depicted in figure 3 and the arrangement depicted in figure 4. The system may be operated in a first mode, using a different local oscillator for each receiver and based on the characteristics of received signals determined. For example, the signal to noise ratio of at least a first received signal may be determined and, if it exceeds a predetermined threshold, the system is switched to a second mode, as depicted in figure 4, in which a single local oscillator is used as an input to each of the receivers. The other local oscillators may then be switched off.

As an alternative to the signal to noise ratio, the bit error rate or the Fourier transform of the input signal can be assessed as signal characteristics in which to determine whether the first or second mode is used. As an example, the second mode may be used if the bit error rate is below a predetermined threshold.

As an alternative to assessing the signal characteristics of a single signal the signal characteristics of all the input signals could be assessed and the second mode may be only used if the signal characteristics of all the input signals fulfil a predetermined criterion.

Each primary mixer and each divider may be coupled to a respective switch (not depicted in figures 3 or 4) operable to switch the input from between the local oscillator 322 and an oscillator from another of the receivers. The switches may be controlled by a controller which controls which oscillator source is used based on the factors described above (e.g. signal to noise ratio, bit error rate, Fourier transform or other signal characteristics). In one example, all the receivers (including both the primary mixer and the divider) use either their respective local oscillator or all use a single source (e.g. from one of the receivers) oscillator. However, in other examples, some receivers may use a local oscillator and others may use a single source oscillator (e.g. from one of the receivers).

Although Figure 4 depicts oscillation signal as originating from the first receiver 30a an oscillation signal from any of the receivers could alternatively be used, and the other oscillators switched off to conserve power.

A further use of the receivers as depicted in figures 3 and 4 may be to adjust the carrier phase. The primary mixer 308 mixes the input signal with a reference signal (either generated by the local oscillator of that receiver or from another receiver) and the divider 324 then divides the reference signal by N, where N is an integer. Thus, the second mixing signal can be chosen from 2πn/N where n ε [0,... ,N-1]. This can be used to control which phase is selected. Conventionally, the phase of the RF carrier cannot be controlled and this provides a way of doing so.

A receiver output can be written as *Iᵣₓ* = *Iₜₓ. cosφ* + *Qₜₓ. sinφ* where φ is the offset between the transmitter and receiver. However, in some scenarios (such as BPSK) only the Iₜₓ component is relevant. Therefore the complex component can be switched off to save power. Iₜₓ can be received and the phase offset tracked. Once the phase offset exceeds a predetermined threshold (for example π/2) the carrier phase can be adjusted.

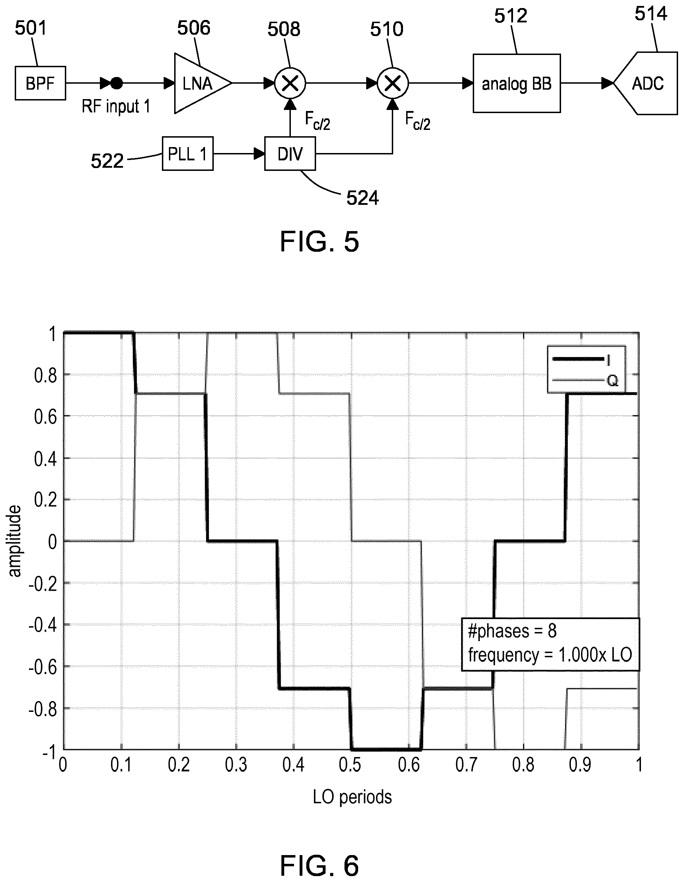

A two stage mixer, each at half the carrier frequency, can be used to reduce leakage between a local oscillator and an input. An example of a cascaded two stage receiver is depicted in Figure 5. There is a primary mixer 508 and a secondary mixer 510 each of which receive mixer signals from divider 524. The divider generates a signal at half the carrier frequency which is used as an input to the primary mixer 508 which mixes the half carrier frequency signal with the received signal.

In this example both the primary mixer and the secondary mixers are eight phase mixers. Each of the primary and secondary mixers mix a half carrier frequency signal from the local oscillator with the respective input signal. An illustrative eight phase mixing waveform is depicted in Figure 6. By using cascaded mixers in this way an RF input signal is converted to a baseband signal.

By using cascaded mixers at half the carrier frequency any leakage from the local oscillator at the primary mixer stage is shifted away by the secondary mixer and is therefore no longer relevant. Any leakage at the secondary mixer stage is easier to control due to the lower frequencies involved. The use of receivers with multi-stage mixers can therefore help to reduce local oscillator leakage.

It should be understood that the scope of the present disclosure is not limited to the example described above. Many variations will be apparent to those skilled in the art, based on the foregoing description.

In the claims, any reference signs placed between parentheses shall not be construed as limiting the claim. The word "comprising" does not exclude the presence of elements or steps other than those listed in a claim. However, where the word "comprising" is used, this also discloses as a special case the possibility that the elements or steps listed are exhaustive - that is, the apparatus or method may consist solely of those elements or steps. The word "a" or "an" preceding an element does not exclude the presence of a plurality of such elements. The embodiments may be implemented by means of hardware comprising several distinct elements. In a device claim enumerating several means, several of these means may be embodied by one and the same item of hardware. The mere fact that certain measures are recited in mutually different dependent claims does not indicate that a combination of these measures cannot be used to advantage. Furthermore, in the appended claims lists comprising "at least one of: A; B; and C" should be interpreted as (A and/or B) and/or C.

In flowcharts, summaries, claims, and descriptions relating to methods, the sequence in which steps are listed is not, in general, intended to be limiting on the order in which they are carried out. The steps may be performed in a different order to that indicated (except where specifically indicated, or where a subsequent step relies on the product of a preceding step). Nevertheless, the order in which the steps are described may in some cases reflect a preferred sequence of operations.

Furthermore, in general, the various embodiments may be implemented in hardware or special purpose circuits, software, logic or any combination thereof. For example, some aspects may be implemented in hardware, while other aspects may be implemented in firmware or software, which may be executed by a controller, microprocessor or other computing device, although these are not limiting examples. While various aspects described herein may be illustrated and described as block diagrams, flow charts, or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

The embodiments described herein may be implemented by computer software executable by a data processor of the apparatus, such as in the processor entity, or by hardware, or by a combination of software and hardware. Further in this regard it should be noted that any blocks of the logic flow as in the Figures may represent program steps, or interconnected logic circuits, blocks and functions, or a combination of program steps and logic circuits, blocks and functions. The software may be stored on such physical media as memory chips, or memory blocks implemented within the processor, magnetic media such as hard disk or floppy disks, and optical media such as for example DVD and the data variants thereof, CD.

The memory may be of any type suitable to the local technical environment and may be implemented using any suitable data storage technology, such as semiconductor-based memory devices, magnetic memory devices and systems, optical memory devices and systems, fixed memory and removable memory. The data processors may be of any type suitable to the local technical environment, and may include one or more of general purpose computers, special purpose computers, microprocessors, digital signal processors (DSPs), application specific integrated circuits (ASIC), gate level circuits and processors based on multi-core processor architecture, as non-limiting examples.

Embodiments as discussed herein may be practiced in various components such as integrated circuit modules. The design of integrated circuits is generally a highly automated process. Complex and powerful software tools are available for converting a logic level design into a semiconductor circuit design ready to be etched and formed on a semiconductor substrate.

## Claims

1. A system comprising a plurality of receivers, each receiver comprising:
a local oscillator configured to generate a local oscillation signal;
a primary mixer configured to mix an input signal with a reference signal at a reference frequency to generate a first output signal;
a divider configured to divide the reference signal into a second reference signal at a second frequency;
a secondary mixer coupled to the primary mixer and configured to mix the first output signal and the second reference signal at the second frequency,
wherein, in a first mode, the reference signal for a first of a plurality of the receivers is the local oscillation signal from the first receiver and, in a second mode, the reference signal is the local oscillation signal from another of the plurality of receivers.

2. The system of claim 1 wherein the system is configured to switch between the first mode and the second mode based on the signal characteristics of the input signal to at least one of the receivers.

3. The system of claim 2 wherein the signal characteristics comprise at least one of the signal to noise ratio, the bit error rate, the Fourier transform of the input signal.

4. The system of either claim 1 or claim 2 wherein the system is configured to switch between the first mode and the second mode based on the signal characteristic of any one signal passing a predetermined threshold.

5. The system of any one of the preceding claims wherein the frequency of the second reference signal is f_{R}/N, where f_{R} is a frequency of the reference signal, and N is an integer.

6. The system according to any one of the preceding claims wherein the primary mixer of each receiver is configured to shift the signal to an intermediate frequency determined by a difference between a frequency of the input signal and a frequency of the reference signal such that the receiver operates in a super-heterodyne mode.

7. The system according to any one of the preceding claims wherein the primary mixer of each receiver is configured to sample the input signal at a plurality of discrete points in time to obtain a discrete-time sampled analog signal based on the reference signal.

8. The system according to claim 7, wherein:
the primary mixer comprises:
a first primary sub-mixer comprising a plurality of in-phase switches including first, second, third, and fourth in-phase switches; and
a second primary sub-mixer comprising a plurality of quadrature-phase switches including first, second, third, and fourth quadrature-phase switches,
and wherein:
the secondary mixer comprises a first set of switches, a second set of switches, a third set of switches, and a fourth set of switches, wherein each of the first, second, third, and fourth sets of switches includes, respectively, a first, a second, a third, and a fourth switch connected in parallel,
an output of each of the first, second, third, and fourth in-phase switches of the primary mixer is coupled to the first set, second set, third set, and fourth set of switches, respectively, of the secondary mixer, and
an output of each of the first, second, third, and fourth quadrature-phase switches of the primary mixer is coupled to the first set, second set, third set, and fourth set of switches, respectively, of the secondary mixer,

9. The system according to claim 8 wherein each receiver further comprises a filter coupled to the secondary mixer and configured to filter an output signal from the secondary mixer, wherein:
the filter comprises a first capacitor and a second capacitor,
outputs of the first set of switches of the secondary mixer are coupled to a first terminal of the first capacitor of the filter and outputs of the second set of switches of the secondary mixer are coupled to a second terminal of the first capacitor of the filter, and
outputs of the third set of switches of the secondary mixer are coupled to a first terminal of a second capacitor of the filter and outputs of the fourth set of switches of the secondary mixer are coupled to a second terminal of the second capacitor of the filter.

10. The system according to any one of claims 7 to 9 wherein the secondary mixer comprises an eight phase mixer.

11. The system according to claim 10 wherein the primary mixer comprises an eight phase mixer.

12. The system according to any one of claims 5 to 8 wherein the second reference signal is offset in phase from the input signal by 2πn/N where n ε [0,... ,N-1].

13. The receiver of any one of claims 8 to 12, wherein:
the secondary mixer comprises a first secondary mixer and a second secondary mixer connected in parallel,
each of the first and second secondary mixers comprises a first set of switches, a second set of switches, a third set of switches, and a fourth set of switches, wherein each of the first, second, third, and fourth sets of switches includes, respectively, a first, a second, a third, and a fourth switch connected in parallel,
an output of each of the first, second, third, and fourth in-phase switches of the first primary mixer is coupled to the first set, second set, third set, and fourth set of switches, respectively, of the first and second secondary mixers,
an output of each of the first, second, third, and fourth quadrature-phase switches of the second primary mixer is coupled to the first set, second set, third set, and fourth set of switches, respectively, of the first and second secondary mixers, and
the second switch and the fourth switch in each of the first, second, third and fourth sets of switches in the first secondary mixer respectively correspond to the fourth switch and the second switch in each of the first, second, third and fourth sets of switches in the second secondary circuit.

14. A method for processing a plurality of input signals, each of the plurality of input signals being received by a plurality of respective receivers, the method comprising, at each receiver:
generating a local oscillation signal;
mixing the input signal with a reference signal to generate a first output signal; and
dividing the reference signal into a second reference signal at a second frequency;
mixing the first output signal with the second reference signal at the second frequency;
the method comprising switching between a first mode in which the reference signal for a first receiver is the local oscillation signal from the first receiver and a second mode in which the reference signal is the local oscillation signal from another of the plurality of receivers.

15. The method of claim 14 wherein switching between the first mode and the second mode is based on the signal characteristics of each of the plurality of input signals being received by at least one of the receivers.
